# EUROPÄISCHE PATENTSCHRIFT

(11) **EP 1 178 595 B1**
(45) Veröffentlichungstag und Bekanntmachung des Hinweises auf die Patenterteilung: **13.09.2006**
(21) Anmeldenummer: 01115975.3
(22) Anmeldetag: 30.06.2001
(51) Int. Cl.: H02M 7/00, H05K 9/00

(54) **Induktivitätsarme Schaltungsanordnung**
Arrangement with a low inductance for circuit
Disposition à faible induction pour circuit

(30) Priorität: 01.08.2000 DE 10037533
(43) Veröffentlichungstag der Anmeldung: 06.02.2002
(73) Patentinhaber: SEMIKRON Elektronik GmbH & Co. KG, 90431 Nürnberg (DE)
(72) Erfinder: Mourick, Paul, Dr., 90766 Fürth (DE)

(56) Entgegenhaltungen:
- WO-A-98/04029
- WO-A-99/66629
- US-A- 4 907 068
- US-A- 5 617 293
- US-A- 5 773 320

## Beschreibung

Die Erfindung beschreibt eine Schaltungsanordnung, insbesondere in Form von Stromrichtern der Leistungsklasse, nach dem Oberbegriff des Anspruches 1, die in ihrer Ausführung auch für Druckkontaktaufbauten geeignet ist. Für Stromrichter der Leistungsklasse wird die Verwendung schnell und verlustarm schaltender Halbleiterschalter bevorzugt. Geeignet sind daher besonders Schaltungsanordnungen mit MOSFETs oder Insulated- Gate- Bipolar- Transistoren (IGBT) und antiparallel dazu geschalteten Freilaufdioden. Derartige Schaltungsanordnungen und damit aufgebaute Stromrichter müssen niederinduktiv ausgelegt werden um die Entstehung von Spannungsspitzen insbesondere bei Abschaltvorgängen zu vermeiden. Dies bedeutet, dass Streuinduktivitäten im Zwischenkreis, an den Anschlussleitern sowie auf der Substratoberfläche der Schaltungsanordnung klein sein müssen. Streuinduktivitäten im Bereich von 20 nH können bei Niedervolt- MOSFET bereits zu Spannungsspitzen führen, welche die Halbleiterschalter zerstören können.

Zum Stand der Technik zählen Einzelschalter und Leistungshalbleitermodule mit einzelnen konstruktiven Maßnahmen zur Reduzierung parasitärer Induktivitäten wie sie z.B. bekannt sind aus EP 0 277 546, DE 39 37 045 oder EP 0 609 528.

In der EP 0 277 546 wird für einen Einzelschalter ein Verfahren zur Reduzierung der parasitären Induktivitäten in den Gleichstromzuleitungen beschrieben. Hierbei werden die beiden Gleichstromzuleitungen eng benachbart und zumindest teilweise parallel zueinander angeordnet. Dies bewirkt eine kleine stromumflossene Fläche in dem Bereich der eng benachbarten Anordnung der Zuleitungen und damit eine geringe Induktivität dieses Zuleitungsabschnittes.

In der DE 39 37 045 wird für eine Halbbrücke ein Verfahren zur Reduzierung der parasitären Induktivitäten in den Gleichstromzuleitungen beschrieben. Hierbei werden die beiden Gleichstromzuleitungen eng benachbart, allerdings mit der Wechselstromzuleitung zwischen Plus- und Minuszuleitung, und zumindest teilweise parallel zueinander angeordnet. Dies bewirkt ebenfalls eine Verkleinerung der stromumflossene Fläche in dem Bereich der eng benachbarten Anordnung der Zuleitungen und damit eine relativ geringe Induktivität dieses Zuleitungsabschnittes.

In der EP 0 609 528 wird ebenfalls für einen Einzelschalter ein Verfahren zur Reduzierung der parasitären Induktivitäten in den parallel und eng benachbarten Gleichstromzuleitungen beschrieben. Zusätzlich werden hier die Halbleiterbauelemente symmetrisch auf dem Substrat angeordnet.

Zum Stand der Technik zählen ebenso Leistungshalbleitermodule in Druckkontakttechnik wie beispielhaft in DE 196 30 173 sowie DE 593 06 387 beschrieben. Derartige Leistungshalbleitermodule bestehen aus keramischen Substraten mit darauf aufgebrachten Kontaktflächen auf denen Halbleiterbauelemente angeordnet sind. Diese Halbleiterbauelemente sind mittels Löten mit den Kontaktflächen verbunden und weisen Bondverbindungen zu andern Halbleiterbauelementen oder anderen isoliert zur ersten Kontaktfläche auf dem Substrat befindlichen zweiten Kontaktflächen auf. Die Druckkontaktierung bezieht sich hierbei auf zwei verschiedene Arten von Kontaktierungen. Einerseits die elektrische Kontaktierung der Anschlussleiter auf die entsprechenden Kontaktflächen des Substrates und andererseits auf die thermische Kontaktierung des Substrates bzw. des gesamten Moduls auf einen Kühlkörper. Bei derartigen Kontaktierung werden beispielhaft Druck übertragende Elemente aus Kunststoff eingesetzt, die einen von aussen auf das Modul einwirkenden Druck auf die Anschlusselemente und / oder auf das Substrat ausüben um einen sicheren elektrischen bzw. thermischen Kontakt herzustellen.

Allen zum Stand der Technik niederinduktiver Schaltungsanordnungen zuordenbaren Erfindungen ist gemein, dass sie eine gewisse Minderung der parasitären Induktivitäten ausschließlich in Teilbereichen des Gesamtsystems Zwischenkreis - Wechselrichter erzielen. Die damit erreichbaren Werte für die Gesamtinduktivität dieses Gesamtsystems liegen derzeit bestenfalls oberhalb von 20 nH.

In der EP 0 277 546 liegen die den Einzelschalter bildenden Transistoren eng benachbart zueinander, dennoch kann der Strom auf unterschiedlichen vor allem unterschiedlich langen Wegen durch die Schaltungsanordnung fließen. Daraus resultieren unterschiedliche vom Strom umflossene Flächen und auch unterschiedliche Induktivitäten für die verschiedenen Leitungswege. Der Aufbau einer Halbbrücke mit derartigen Einzelschaltern kann aufgrund der dafür notwendigen externen Verschaltung keinesfalls niederinduktiv erfolgen. Dies führt in der Summe der Eigenschaften zu einer gewissen Reduzierung der parasitären Induktivitäten des Gesamtsystems Zwischenkreis - Wechselrichter. Allerdings sind damit noch nicht alle Forderungen an eine Minimierung der parasitären Induktivitäten erfüllt.

In der DE 39 37 045 wird das Ziel einer minimalen parasitären Induktivität aus zwei wesentlichen Gründen verfehlt. Erstens sind die Gleichstromanschlussleiter nicht in minimalem Abstand zueinander angeordnet, da hier der Wechselstromanschlussleiter zwischen den beiden Gleichstromanschlussleitem angeordnet ist. Somit ist die stromumflossene Fläche im Bereich der Gleichstromanschlussleiter nicht minimal und daher sind auch die Induktivitäten für diesen Bereich nicht minimal. Zweitens sind die Leistungstransistoren des ersten und zweiten Leistungsschalters relativ weit von einander angeordnet, was ebenfalls die parasitären Induktivitäten erhöht.

Der vorliegenden Erfindung liegt die Aufgabe zu Grunde die parasitären Induktivitäten einer Schaltungsanordnung sowohl im Bereich der Anschlussleitungen als auch im Bereich der Halbleiterbauelemente, aufgebaut auf einem elektrisch isolierenden Substrat, soweit zu optimieren, dass die Gesamtinduktivität dieser Anordnung in der Größenordnung von 1nH oder kleiner also um mindestens eine Größenordnung unter dem Stand der Technik liegt.

Diese Aufgabe wird dadurch gelöst, dass die stromumflossene Fläche der gesamten Schaltungsanordnung vom Plus- bis zum Minusanschluss des Zwischenkreises in ihrer Gesamtheit durch folgende Maßnahmen minimiert wird:
- Die ersten und zweiten Leistungsschalter sind auf dem Substrat eng benachbart angeordnet.
- Die ersten und zweiten Leistungsschalter liegen in einer Reihe und sind somit möglichst kurz miteinander verbunden.
- Die Leistungstransistoren, welche die ersten und zweiten Leistungsschalter bilden, sowie etwaige Freilaufdioden liegen ebenfalls eng benachbart in Reihe.
- Die Anschlussleitungen des Plus- und Minusanschlusses sind als Bänder ausgeführt
- Die Anschlussleitungen des Plus- und Minusanschlusses sind in Ihrem Verlauf bis nahe an das Substrat parallel angeordnet.
- Die Anschlussleitungen des Plus- und Minusanschlusses sind nur durch eine Isolationsschicht getrennt eng benachbart.
- Ein Abschnitt des Anschlussband mindesten eines der beiden Gleichstromanschlüsse ist nahe des Substrates parallel zu diesem angeordnet und befindet sich in möglichst geringem Abstand oberhalb der Leistungstransistoren.
- Der jeweilige parallel zum Substrat gelegene Abschnitt des mindestens einen Gleichstromanschlusses ist mit Stegen versehen. Diese Stege reichen im Bereich zwischen den Leistungstransistoren der Leistungsschalter bis auf die Grundplatte hinab und sind von dieser nur durch eine zur Isolation notwendige Schicht getrennt.
- Die Stege können durch die beschriebenen Anordnung auch als Druckkontaktierung des Substrates auf einem Kühlkörper dienen. Dadurch können sie zumindest teilweise Druckelemente nach dem Stand der Technik ersetzen.

Durch diese Maßnahmen wird sowohl in der Substratebene, als auch in allen dazu senkrechten durch die Anschlussleitungen definierten Ebenen, die Induktivität minimiert.

Die Erfindung wird anhand eines Ausführungsbeispiels in Verbindung mit den Fig. 1 bis 7 näher erläutert Spezielle Ausgestaltungen finden sich in den Ansprüchen 1 bis 7. Es zeigen:
Fig. 1 zeigt schematisch eine dem Stand der Technik entsprechende Halbbrücke sowie deren stromumflossenen Bereich.
Fig. 2 zeigt eine Halbbrücke nach Fig. 1 mit mehreren Leistungstransistoren, sowie den maximalen stromumflossenen Bereich dieser Anordnung.
Fig. 3 zeigt einen Aufbau des Substrates sowie der Leistungsschalter einer Halbbrücke nach dem Stand der Technik, sowie den in dieser Anordnung maximalen stromumflossenen Bereich.
Fig. 4 zeigt einen Ausschnitt einer erfindungsgemäße Schaltungsanordnung.
Fig. 5 zeigt den stromumflossenen Bereich der Anschlussleitungen nach dem Stand der Technik.
Fig. 6 zeigt den stromumflossenen Bereich der erfindungsgemäßen Anordnung der Anschlussleitungen.
Fig. 7 zeigt eine dreidimensionalen Ausschnitt der erfindungsgemäßen Schaltungsanordnung.

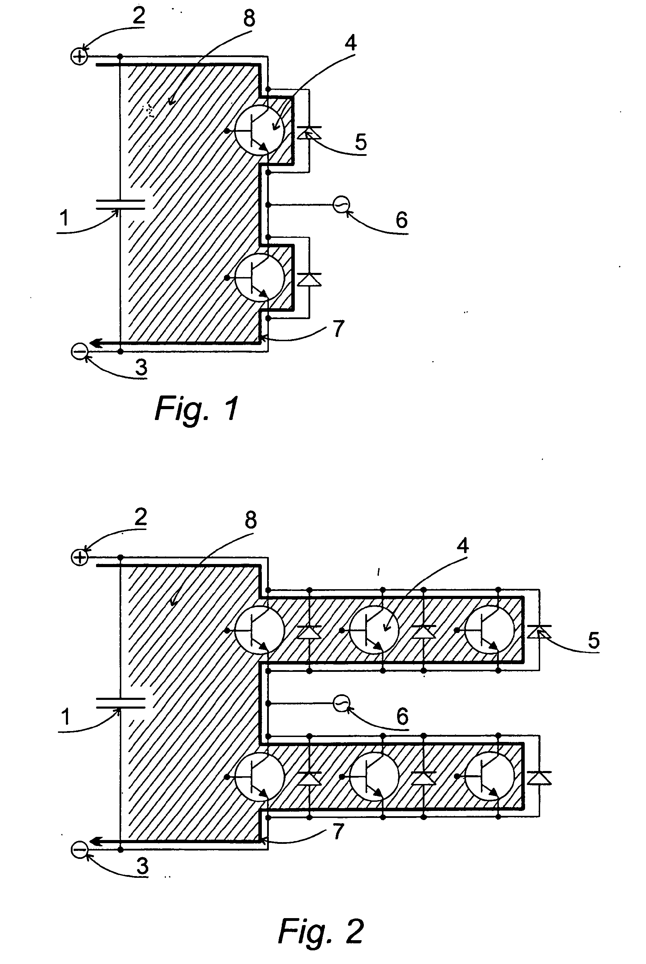

Fig. 1 zeigt eine schematische Darstellung einer Halbbrücke. Der typische Aufbau nach dem Stand der Technik besteht aus einem Zwischenkreis mit Kondensator (1) mit den Plus- (2) und Minusanschlüssen (3), sowie den Leistungsschaltern (4). Diese Leistungsschalter können als MOSFET oder IGBT realisiert sein. Im Falle der Realisierung mit IGBTs sind zusätzliche Freilaufdioden (5) notwendig. Der Wechselstromanschluss ist mit (6) bezeichnet. Der Pfeil (7) symbolisiert den Stromfluß von Plus nach Minus während eines Kommutierungsvorganges, der schraffierte Bereich die dabei stromumflossene Fläche (8). Die Größe der stromumflossenen Fläche ist ein direktes Maß für die auftretenden parasitären Induktivitäten, sie bildet anschaulich den Querschnitt einer Spule mit einer Wicklung.

Fig. 2 verdeutlicht den realistischen Fall der Schaltungsanordnung nach Fig. 1 wobei die ersten und zweiten Leistungsschalter jeweils durch mehrere parallel geschaltete Leistungstransistoren realisiert werden. In diesem Fall symbolisierte der schraffierte Bereich (8) die maximale vom Strom umflossene Fläche. Hier zeigt sich, dass diese Flächen und damit die entsprechenden Induktivitäten für die jeweiligen Leistungstransistoren unterschiedlich sind.

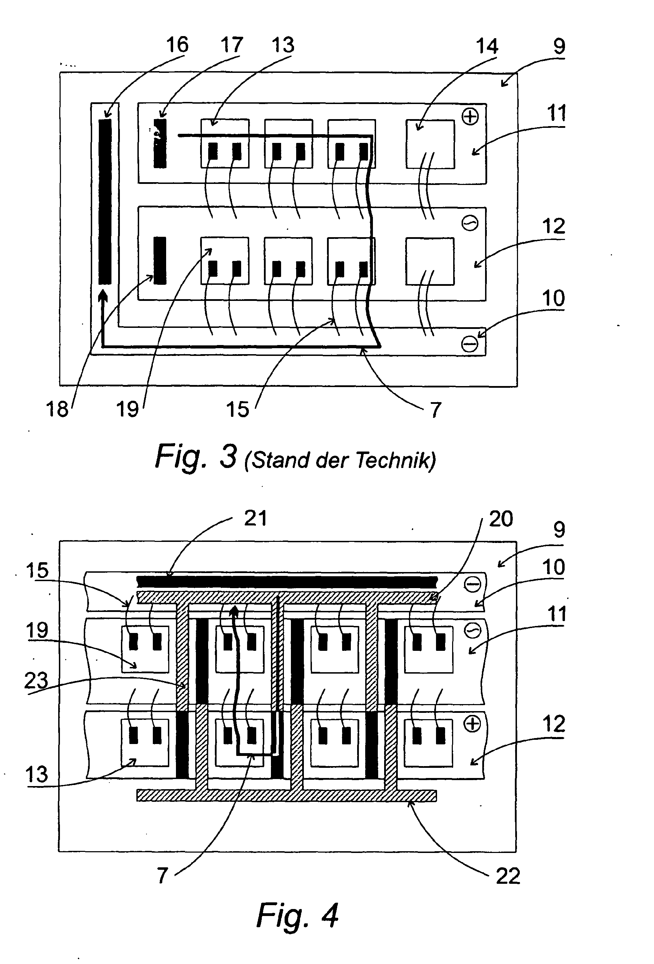

Fig. 3 zeigt den Stand der Technik der Realisierung des Substrates einer Halbbrücke. Der Übersichtlichkeit halber sind Hilfsanschlüsse, wie Gate-, Basis- oder Hilfsemitter nicht berücksichtigt. Auf einem Keramiksubstrat (9) sind die kupferkaschierten Flächen für die Plus- (11), die Minus- (10) sowie den Wechselstromanschluss (12) angeordnet. Auf der Plusfläche befinden sich hierbei erste Leistungstransistoren (13), die einen ersten Leistungsschalter realisieren, sowie eine Freilaufdiode (14). Die Emitter der Leistungstransistoren sind mittels Bonddrähten (15) mit der kupferkaschierten Fläche (12) des Wechselstromanschlusses verbunden. Auf dieser Fläche sind zweite Leistungstransistoren angeordnet, sowie ebenfalls eine Freilaufdiode. Diese zweiten Leistungstransistoren sind mittels Bonddrähten mit der kupferkaschierten Fläche (10) des Minusanschlusses verbunden. Die zum Zwischenkreis führenden Plus- (17) und Minus- (16) sowie der Wechselstromanschlussleiter (18) sind ebenfalls auf den ihrer Polarität entsprechenden kupferkaschierten Flächen angeordnet. Typisch für derartige Anordnungen nach dem Stand der Technik ist bereits eine eng benachbarte Anordnung der Plus- und Minusanschlussleiter, zumindest bis zu einem geringen Abstand oberhalb des Substrates. Der Pfeil (7) kennzeichnet hier ebenfalls die maximale vom Strom umflossene Fläche. Diese Fläche bestimmt die parasitäre Induktivität dieser Schaltungsanordnung. Mit derartigen Schaltungsanordnungen lassen sich bezogen auf die Ebene des Substrates typische Induktivitäten im Bereich von 20 bis 50 nH erreichen.

Fig. 4 zeigt einen Ausschnitt der erfinderische Lösung der Schaltungsanordnung, wobei hier die Anschlussleiter integraler Bestandteil der Anordnung zur Erzielung minimaler Induktivitäten im Bereich des Substrates sind. Hier wurde ebenfalls im Hinblick auf eine übersichtliche Darstellung auf die notwendigen Hilfsanschlüsse verzichtet. Auf dem Substrat (9) sind nach dem Stand der Technik kupferkaschierten Flächen für den Plus- (12), den Minus- (10) sowie den Wechselstromanschluss (11) angeordnet. Der erfinderische Gedanke besteht in der Kombination zweier Merkmale.

Erstens müssen für minimale parasitäre Induktivitäten die ersten Leistungstransistoren (13) (beispielhaft MOSFET) möglichst eng benachbart an den zweiten Leistungstransistoren (19) und die ersten und zweiten Leistungstransistoren in Reihe angeordnet sein.

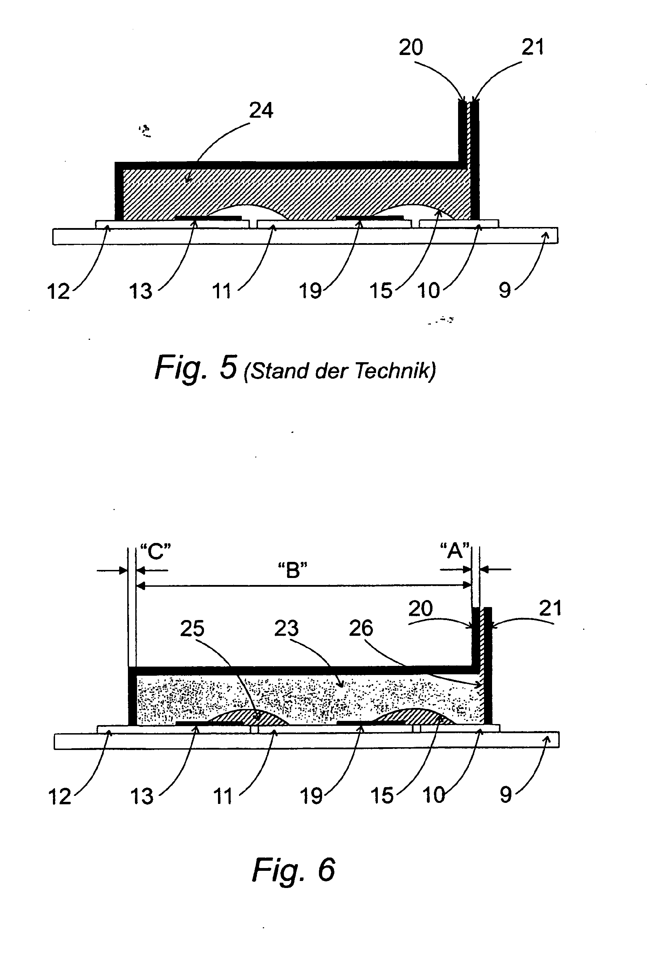

Zweitens werden die Plus- (20) und Minusanschlussleitungen (21) in bandartiger Ausführung in die Stromführung mit einbezogen. Zur Beschreibung werden diese beiden Anschlussleitungen in Abschnitte (dargestellt in Fig. 6) eingeteilt:

Abschnitt "A" reicht vom Zwischenkreisanschluss bis nahe an die Substratoberfläche. Abschnitt "B" verläuft parallel zur Substratoberfläche, sowie
Abschnitt "C", der sich an den parallel verlaufenden Bereich anschließt und die typischerweise senkrechte Kontaktierung auf die entsprechende kupferkaschierte Fläche der Substratoberfläche darstellt. Wenigstens eine der beiden Gleichstromanschlussleitungen wird derart ausgeführt. Der Abschnitt B weist die für den erfinderischen Gedanken entscheidende Charakteristik auf, indem er nicht ausschließlich als Band parallel zur Substratoberfläche angeordnet ist, sondern in jedem Bereich zwischen den in Reihe angeordneten ersten und zweiten Leistungstransistoren zu diesen wenigstens einen parallel verlaufenden Steg aufweist. Diese Stege reichen bis auf die Substratoberfläche hinab und sind von den kupferkaschierten Flächen der jeweils anderen Leitungstypen nur durch eine dünne Isolationsschicht getrennt.

Die Plusanschlussleitung (20) ist im Abschnitt "A" parallel zur Minusanschlussleitung (21) angeordnet und in diesem Bereich von jener nur durch eine Isolationsschicht getrennt. Vom Abschnitt "B" sind nur die Stege (23) gezeichnet, der bandartige oberhalb diese Stege verlaufende und die Stege verbindende Teil ist nicht gezeichnet. Die parallelen Stege sind im Bereich der Schraffur von der Oberfläche des Substrates und den dort lokalisierten kupferkaschierten Minus- (10) und Wechselstromflächen (11) durch eine dünne Isolierschicht getrennt. Im flächig gezeichnet Bereich ist sind die Stege stoffbündig oder stoffschlüssig mit der Kupferkaschierung verbunden. In analoger Weise gilt dies auch für die Wechselstromanschlussleitung. Der Pfeil (7) skizziert hier ebenfalls die maximale vom Strom umflossene Fläche. Die stromumflossene Fläche bezogen auf die Ebene des Substrates wird durch diese Anordnung minimiert. Weiterhin ergibt sich durch die Symmetrie dieser Anordnung für alle Leistungstransistoren eine gleichmäßige Strombelastung und gleiche parasitäre Induktivitäten.

Mit derartigen Schaltungsanordnungen lassen sich bezogen auf die Ebene des Substrates Induktivitäten in der Größenordnung von 1 nH und kleiner erreichen.

Die Wechselstromanschlussleitung (22) ist in gleicher Weise realisiert wie die Plusanschlussleitung (20), also bandartig mit Stegen bis auf die DCB- Keramik hinabreichend.

Fig. 5 zeigt nach dem Stand der Technik eine durch die Anschlussleitungen definierte Ebene senkrecht zum Substrat (9). Auf diesem Substrat (9) sind die kupferkaschierten Flächen für den Plus- (12), den Minus- (10) sowie den Wechselstromanschluss (11) angeordnet. Auf der Plusfläche (12) befindet sich hier ein erster Leistungstransistor (13). Ein zweiter Leistungstransistor (19) befindet sich auf der Wechselstromfläche (11). Der Emitter des ersten Leistungstransistors (13) ist mittels Bonddrähten (15) mit der kupferkaschierten Fläche (11) des Wechselstromanschlusses verbunden. Der Emitter des zweiten Leistungstransistors ist ebenfalls mittels Bonddrähten (15) mit der kupferkaschierten Fläche (10) des Minusanschlusses verbunden. Die in dieser Ebene vom Strom umflossene Fläche (24) erstreckt sich unterhalb des Plusanschlussleiters bis zur Oberfläche des Substrates, bzw. im Bereich der Bondverbindungen bis zu diesen.

Fig. 6 zeigt den erfinderischen Gedanken ebenfalls in der durch die Anschlussleitungen definierte Ebene senkrecht zum Substrat (9). Die drei Abschnitte "A", "B" und "C" einer Anschlussleitung sind hier ebenfalls dargestellt. Durch die erfinderischen Stege (23), die bis zur Oberfläche des Substrates herabreichen, unterhalb des bandartigen Teiles des Plusanschlussleiters wird dieser Bereich nicht mehr von Strom umflossen. Der Stromfluss zur kupferkaschierten Fläche (12) findet nun direkt oberhalb des Substrates, der weitere Stromfluss zum Minusanschlussleiter findet im Substrat bzw. in den Abschnitten mit Bondverbindungen durch diese statt. Damit ergeben sich drei signifikante stromumflossene Flächen. Der Bereich (26) zwischen der Minus- und dem Plusanschlussleitung, sowie die Bereiche (25) nach oben begrenzt durch die Bonddrähte, nach unten durch die Unterseite der erfinderischen Stege (23). Ein Vergleich mit Fig. 5 zeigt deutlich die Reduzierung der stromumflossenen Fläche und damit eine Reduzierung der parasitären Induktivitäten der erfinderischen Schaltungsanordnung. Um eine vollständig niederinduktive Schaltungsanordnung zu erzielen müssen die Zwischenkreiskondensatoren direkt an den Gleichstromzuleitungen angeordnet werden.

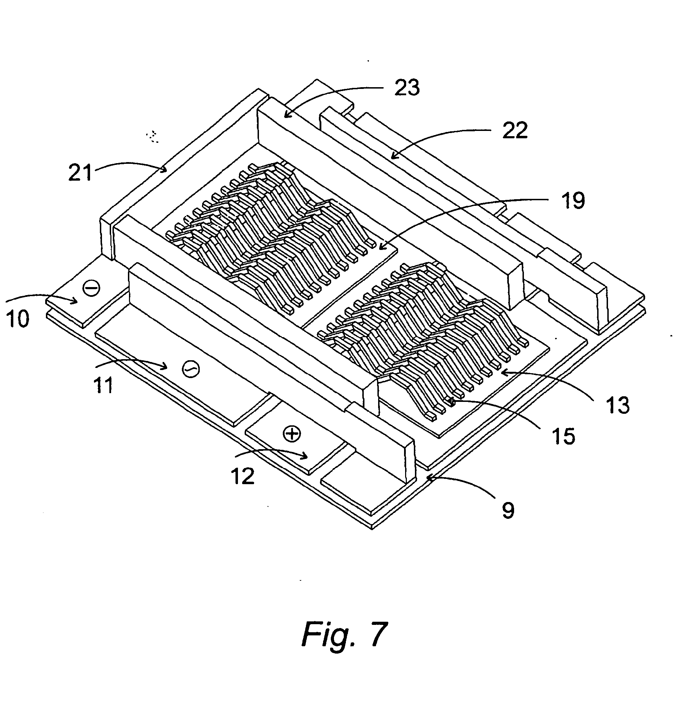

Fig. 7 zeigt in einer dreidimensionale Skizze einen Ausschnitt der erfinderischen Idee. Es sind hier jeweils ein erster (13) sowie ein zweiter (19) Leistungstransistor dargestellt. In dieser Abbildung nicht gezeichnet sind wiederum alle Hilfsanschlüsse, sowie der geschlossene bandartige Teil der Anschlussleitungen, welcher sich oberhalb des Substrates über den Stegen befindet und im Bedarfsfall nur unterbrochen ist um Anschlussleitungen für Hilfsanschlüsse hindurch zu führen. Die Stege (23) des Plus- (12), des Minus- (10) sowie des Wechselstromanschlussleiters (11) können zusätzlich zu ihrer Aufgabe die Induktivitäten in den Anschlussleitungen minimal zu halten ebenfalls als Druck weiterleitende Element für druckkontaktierte Aufbauten dienen. Jeder der genannten Anschlussleiter hat über die Stege direkten Kontakt zu der ihm zugeordneten kupferkaschierten Fläche und kann in Druckkontaktaufbauten sowohl zur elektrischen Druckkontaktierung des Anschlusses selbst als auch zur thermischen Druckkontaktierung des Substrats auf einen Kühlkörper dienen. Diesen Zweck des thermischen Druckkontakts kann jeder Steg eines Anschlussleiters ebenfalls auf die ihm nicht zugeordneten kupferkaschierten Flächen ausüben, da er von dieser nur durch eine isolierende Schicht, typischerweise eine Kunststofffolie, getrennt ist.

## Patentansprüche

1. Schaltungsanordnung mit geringen parasitären Induktivitäten bestehend aus einem elektrisch isolierenden Substrat (9) mit darauf befindlichen gegeneinander isolierten metallischen Verbindungsbahnen darauf befindlichen ersten und zweiten in Reihe geschalteten Leistungsschaltern, bestehend jeweils aus mehreren parallel geschalteten ersten (13) und zweiten (19) Leistungstransistoren sowie Gleich- (20, 21) und Wechselstromanschlussleitem (22) die jeweiligen ersten (13) und zweiten (19) Leistungstransistoren eng benachbart und in einer Reihe angeordnet sind, die Gleichstromanschlussleiter (20, 21) in einem ersten Abschnitt bandartig, eng benachbart und parallel bis nahe an die Substratoberfläche (9) oder diese kontaktierend angeordnet sind sowie mindestens ein Gleichstromanschlussleiter (20) einen zweiten bandartigen Abschnitt parallel zur Substratoberfläche (9) mit daran angeordneten Stegen (23) aufweist, **dadurch gekennzeichnet dass** diese Stege (23) teilweise nur durch eine Isolationsschicht vom Substrat getrennt sind sowie mindestens eine Kontaktstelle (12) mit der Substratoberfläche (9) aufweisen.

2. Schaltungsanordnung nach Anspruch 1 und 3, **dadurch gekennzeichnet, dass**
die Stege (23) zwischen den Leistungstransistoren (13. 19) angeordnet sind und mindestens ein Gleichstromanschlussleiter (20) als druckübertragende Elemente für einen druckkontaktierten Aufbau des Moduls ausgebildet ist.

3. Schaltungsanordnung nach Anspruch 1 oder 4, **dadurch gekennzeichnet, dass**
die ersten und zweiten Leistungsschalter durch zwei Reihen von Leistungstransistoren symmetrisch zur Mittenachse des Substrats plaziert sind.

4. Schaltungsanordnung nach einem der Ansprüche 1 bis 5, **dadurch gekennzeichnet, dass**
die Leistungstransistoren IGBT oder MOS- FETs sind.

5. Schaltungsanordnung nach einem der Ansprüche 1 bis 5, **dadurch gekennzeichnet, dass**
außer Transistoren auch eine oder mehrere Freilaufdioden einen Leistungsschalter bilden und mit den jeweils zugehörigen Leistungstransistoren in einer Reihe angeordnet sind.

## Claims

1. Switching device with low parasitic inductances, consisting of an electrically insulating substrate (9) with metal connecting paths insulated against each other and mounted on it, and first and second series connected power switches mounted on it, each consisting of a plurality of parallel switched first (13) and second (19) power transistors, as well as direct (20, 21) and alternating current connection conductors (22),wherein the first (13) and second (19) power transistor is arranged adjacent to each other and in one row and the direct current connection conductors (20, 21) are arranged in strip manner in a first section, so that they lie close together and are parallel as far as a point close to the substrate surface (9), or are arranged in contact with them, and wherein at least one direct current connection conductor (20)has a second strip type section parallel with the substrate surface (9), with webs (23) arranged on it, **characterised in that** these webs (23) are partially separated from the substrate only by one insulation layer, and have at least one point of contact (12) with the substrate surface (9).

2. The switching device according to Claim 1, **characterised in that** the webs (23) are arranged between the power transistors (13, 19) and at least one direct current connection conductor (20) is designed as pressure transmitting elements for a pressure contacted structure of the module.

3. The switching device according to Claim 1 or 2, **characterised in that** the first and second power switches are positioned by two rows of power transistors symmetrically to the central axis of the substrate.

4. The switching device according to any one of Claims 1 to 3, **characterised in that** the power transistors are IGBT's or MOS-FET's.

5. The switching device according to any one of Claims 1 to 4, **characterised in that** in addition to transistors, one or more self-induction recuperation diodes form a power switch and are arranged in one row with each of the associated power transistors.

## Revendications

1. Montage à faibles inductances parasitaires, constitué d'un substrat (9) électriquement isolant sur lequel sont appliquées des voies de liaison métalliques isolées les unes par rapport aux autres, sur lesquelles se trouvent des premiers et des deuxièmes interrupteurs de puissance couplés en série, qui sont respectivement constitués de plusieurs premiers transistors de puissance (13) et deuxièmes transistors de puissance (19) couplés en parallèle, ainsi que de conducteurs de raccordement de courant continu (20, 21) et de courant alternatif (22), les premiers transistors de puissance (13) et deuxièmes transistors de puissance (19) respectifs étant disposés de façon étroitement adjacente et sur une rangée, les conducteurs de raccordement de courant continu (20, 21) étant disposés en forme de bande dans un premier tronçon en étant étroitement adjacents, et parallèlement jusqu'à proximité de la surface du substrat (9) ou en étant en contact avec celle-ci, et au moins un conducteur de raccordement de courant continu (20) comportant un deuxième tronçon en forme de bande parallèlement à la surface du substrat (9), sur lequel sont disposées des barrettes (23),
**caractérisé en ce que** ces barrettes (23) ne sont partiellement séparées du substrat que par une couche d'isolation, et comportent au moins un point de contact (12) avec la surface du substrat (9).

2. Montage selon les revendications 1 et 3,
**caractérisé en ce que** les barrettes (23) sont disposées entre les transistors de puissance (13, 19), et **en ce qu'**au moins un conducteur de raccordement de courant continu (20) est réalisé en tant qu'élément de transmission de pression pour un agencement à contact par pression du module.

3. Montage selon la revendication 1 ou 4,
**caractérisé en ce que** les premier et deuxième interrupteurs de puissance sont placés symétriquement par rapport à l'axe médian du substrat par deux rangées de transistors de puissance.

4. Montage selon l'une des revendications 1 à 5, **caractérisé en ce que** les transistors de puissance sont des IGBT ou des MOSFET.

5. Montage selon l'une des revendications 1 à 5, **caractérisé en ce que**, outre des transistors, une ou plusieurs diodes de roue libre forment également un interrupteur de puissance, et sont disposées sur une rangée avec les transistors de puissance respectivement associés.
